(19) Europäisches Patentamt / European Patent Office / Office européen des brevets

(11) **EP 3 579 151 B1**

(12) **FASCICULE DE BREVET EUROPEEN**

(45) Date de publication et mention
de la délivrance du brevet:
**02.12.2020 Bulletin 2020/49**

(51) Int Cl.:
**G06N 3/063** *(2006.01)*    **H01L 27/24** *(2006.01)*

(21) Numéro de dépôt: **19177078.3**

(22) Date de dépôt: **28.05.2019**

(54) **PROCEDE DE FABRICATION D'UN CALCULATEUR A RESEAUX DE NEURONES RECURRENTS**

HERSTELLUNGSVERFAHREN EINES RECHNERS MIT REKURRENTEN NEURONALEN NETZEN

METHOD FOR MANUFACTURING A COMPUTER WITH RECURRENT NEURAL NETWORKS

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **05.06.2018 FR 1854877**

(43) Date de publication de la demande:
**11.12.2019 Bulletin 2019/50**

(73) Titulaire: **Commissariat à l'Energie Atomique et
aux Energies
Alternatives
75015 Paris (FR)**

(72) Inventeurs:
• **VIANELLO, Elisa
38054 GRENOBLE Cedex 09 (FR)**
• **LA BARBERA, Selina
38054 GRENOBLE Cedex 09 (FR)**
• **NODIN, Jean-François
38054 GRENOBLE Cedex 09 (FR)**
• **TIRON, Raluca
38054 GRENOBLE Cedex 09 (FR)**

(74) Mandataire: **INNOV-GROUP
310, avenue Berthelot
69372 Lyon Cedex 08 (FR)**

(56) Documents cités:
**US-A1- 2010 220 523    US-A1- 2012 052 598
US-A1- 2014 214 738    US-A1- 2015 104 946**

• **DEMIS E C ET AL: "Atomic switch
networks-nanoarchitectonic design of a complex
system for natural compu",
NANOTECHNOLOGY, IOP, BRISTOL, GB, vol. 26,
no. 20, 27 avril 2015 (2015-04-27), page 204003,
XP020283967, ISSN: 0957-4484, DOI:
10.1088/0957-4484/26/20/204003 [extrait le
2015-04-27]**

## Description

## Domaine technique

L'invention se rapporte au domaine technique des calculateurs à réseaux de neurones récurrents. Les réseaux de neurones récurrents sont des réseaux de neurones artificiels où les connexions entre les unités forment au moins un cycle au sens de la théorie des graphes. Plus précisément, le domaine technique concerne les réseaux de neurones récurrents entraînés par le paradigme « *Reservoir computing* ». Ce paradigme est un système dynamique hautement non-linéaire, comportant :

- une couche d'entrée ;
- une couche cachée, appelée réservoir, munie de connexions récurrentes fixées de manière aléatoire ;
- une couche de sortie (« *readout»* en langue anglaise).

Le principe de ce paradigme est de projeter la couche d'entrée vers le réservoir, puis de modifier les connexions allant du réservoir vers la couche de sortie par un apprentissage supervisé.

En d'autres termes, l'invention se rapporte à un calculateur qui est une implémentation physique ou matérielle (« *hardware* » en langue anglaise) du paradigme « *Reservoir computing* ».

L'invention trouve notamment son application dans la classification de tâches, l'extraction de caractéristiques, la poursuite d'objets (« *tracking»* en langue anglaise), la prédiction de mouvements en robotique, la reconnaissance vocale et la reconnaissance sonore.

## Etat de la technique antérieure

Un procédé de fabrication d'un calculateur à réseaux de neurones récurrents, connu de l'état de la technique, notamment du document « AtoMïc switch networks - nanoarchitectonic design of a complex system for natural computing », E.C. Demis et al., Nanotechnology, 26, 204003, 2015, comporte une étape de croissance aléatoire de nanofils d'argent sur une électrode structurée de platine. Le caractère aléatoire est obtenu par une étape préalable de formation de microsphères de cuivre sur l'électrode structurée. Les microsphères de cuivre forment une couche germe pour les nanofils d'argent. Le procédé comporte une étape de sulfuration des nanofils d'argent de manière à obtenir des structures du type $Ag/Ag_2S/Ag$. De telles structures forment des cellules de mémoire résistive de type interrupteur atomique.

Un tel procédé de l'état de la technique permet la fabrication d'un calculateur qui est une implémentation physique du paradigme *« Reservoir computing »*. Toutefois, un tel procédé de l'état de la technique n'est pas entièrement satisfaisant dans la mesure où le choix des matériaux pour la mémoire résistive est restreint. En effet, il est nécessaire de choisir un couple de matériaux compatible, de type conducteur électrique/diélectrique, pour la formation des nanofils et des cellules de mémoire résistive, en l'espèce $Ag/Ag_2S$.

## Exposé de l'invention

L'invention vise à remédier en tout ou partie aux inconvénients précités. A cet effet, l'invention a pour objet un procédé de fabrication d'un calculateur à réseaux de neurones récurrents, comportant les étapes successives :

a) prévoir un substrat comportant une couche diélectrique ;
b) former une première couche de copolymères à blocs sur une partie de la couche diélectrique de sorte que la couche diélectrique présente des zones libres avec une distribution spatiale aléatoire ;
c) graver les zones libres de la couche diélectrique de manière à structurer la couche diélectrique ;
d) retirer la première couche de copolymères à blocs ;
d') former une première électrode sur la couche diélectrique structurée lors de l'étape c) ;
e) former une couche mémoire, de type mémoire résistive, sur la première électrode ;
f) former une deuxième électrode sur la couche mémoire ;
g) former une deuxième couche de copolymère à blocs sur une partie de la deuxième électrode de sorte que la deuxième électrode présente des zones libres avec une distribution spatiale aléatoire ;
h) graver les zones libres de la deuxième électrode de manière à structurer la deuxième électrode ;
i) retirer la deuxième couche de copolymères à blocs.

Ainsi, un tel procédé selon l'invention permet l'implémentation physique d'un calculateur à réseaux de neurones récurrents pouvant être entraînés par le paradigme « *Reservoir Computing* ». En effet, les copolymères à bloc possèdent la propriété de s'auto-assembler en réseaux denses d'objets nanométriques avec la capacité de former un masque de lithographie.

Cet auto-assemblage introduit le caractère aléatoire nécessaire dans le paradigme « *Reservoir Computing* », c'est-à-dire par exemple :

- des connexions récurrentes fixées de manière aléatoire dans le réservoir ;
- un nombre stochastique d'unités (une unité correspondant à une cellule de mémoire résistive, située à une intersection entre les première et deuxième électrodes) ;
- un temps de latence aléatoire entre les unités (e.g. une distance aléatoire entre les unités) ;
- un poids aléatoire des unités par une conductance aléatoire des cellules de la mémoire résistive (les cellules de la mémoire résistive étant formées par les zones d'intersection entre la couche mémoire et les première et deuxième électrodes).

En outre, le masque de lithographie ainsi formé par les première et deuxième couches de copolymères à blocs permet de structurer la couche diélectrique et la deuxième électrode lors des étapes c) et h). La première électrode est également structurée lors de l'étape d') en étant formée sur la couche diélectrique structurée, par exemple par un dépôt conforme. La couche mémoire est également structurée lors de l'étape e) en étant formée sur la première électrode structurée, par exemple par un dépôt conforme.

Enfin, un tel procédé selon l'invention autorise une liberté sur le choix du matériau de la couche mémoire dans la mesure où la couche mémoire est formée indépendamment des première et deuxième couches de copolymères à blocs.

## Définitions

- Par « électrode structurée », on entend une électrode présentant une surface discontinue délimitant un ensemble de motifs.
- Par « couche diélectrique structurée », on entend une couche (ou une pluralité de sous-couches) diélectrique(s) présentant une surface discontinue délimitant un ensemble de motifs.
- Par « zones libres » on entend des zones de la couche diélectrique ou de la deuxième électrode qui ne sont pas recouvertes par la couche de copolymère à blocs.
- Par « couche mémoire », on entend une couche ou une pluralité de sous-couches (par exemple réalisée(s) dans un matériau de type oxyde ou de type chalcogénure) formant, avec les première et deuxième électrodes, une mémoire résistive (ReRam « *Resistive random-access memory* » en langue anglaise). Plus précisément, les cellules de la mémoire résistive sont situées aux intersections entre les première et deuxième électrodes.

Le procédé selon l'invention peut comporter une ou plusieurs des caractéristiques suivantes.

Selon une caractéristique de l'invention, l'étape b) comporte les étapes successives :

b$_1$) former une couche d'un polymère aléatoire sur la couche diélectrique ;
b$_2$) greffer la couche du polymère aléatoire sur une partie de la couche diélectrique ;
b$_3$) former la première couche de copolymères à blocs sur la couche du polymère aléatoire greffée lors de l'étape b$_2$) ;

b$_4$) retirer la couche du polymère aléatoire greffée.

Par « polymère aléatoire », on entend un polymère possédant une pelote aléatoire.

Ainsi, la couche du polymère aléatoire est une couche de fonctionnalisation permettant de contrôler les énergies de surface de la couche diélectrique. Un avantage procuré est d'accentuer le caractère aléatoire et d'améliorer la qualité de la formation de la première couche de copolymères à blocs.

Selon une caractéristique de l'invention, l'étape g) comporte les étapes successives :

g$_1$) former une couche d'un polymère aléatoire sur la deuxième électrode ;
g$_2$) greffer la couche du polymère aléatoire sur une partie de la deuxième électrode ;
g$_3$) former la deuxième couche de copolymères à blocs sur la couche du polymère aléatoire greffée lors de l'étape g$_2$) ;
g$_4$) retirer la couche du polymère aléatoire greffée.

Ainsi, la couche du polymère aléatoire est une couche de fonctionnalisation permettant de contrôler les énergies de surface de la deuxième électrode. Un avantage procuré est d'accentuer le caractère aléatoire et d'améliorer la qualité de la formation de la deuxième couche de copolymères à blocs. En outre, le caractère aléatoire est accentué par la topologie de surface de la couche mémoire issue de la structuration de la couche diélectrique lors de l'étape c).

Selon une caractéristique de l'invention, le polymère aléatoire est sélectionné dans le groupe comportant un copolymère statistique, un homopolymère, une monocouche auto-assemblée.

Selon une caractéristique de l'invention, les copolymères à blocs de la première couche et de la deuxième couche sont sélectionnés dans le groupe comportant :

- le polystyrène et le polyméthacrylate de méthyle, noté PS-PMMA ;
- le polystyrène et l'acide polylactique, noté PS-PLA ;
- le polystyrène et le poly(oxyde d'éthylène), noté PS-PEO ;
- le polystyrène et le polydiméthylsiloxane, noté PS-PDMS ;
- le polystyrène, le polyméthacrylate de méthyle, et le poly(oxyde d'éthylène), noté PS-PMMA-PEO,
- le polystyrène et le poly(2-vinyl pyridine), noté PS-P2VP.

Selon une caractéristique de l'invention, la couche mémoire est réalisée dans au moins un matériau sélectionné dans le groupe comportant $HfO_2$, $Al_2O_3$, $SiO_2$, ZrO, un oxyde de titane, un chalcogénure, $Ta_2O_5$.

Selon une caractéristique de l'invention, les première et deuxième électrodes sont réalisées dans au moins un matériau sélectionné dans le groupe comportant Ti, TiN, Pt, Zr, Al, Hf, Ta, TaN, C, Cu, Ag.

Selon une caractéristique de l'invention, la première couche de copolymères à blocs et la deuxième couche de copolymères à blocs formées respectivement lors des étapes b) et g) présentent une épaisseur comprise entre 30 nm et 50 nm.

Ainsi, un avantage procuré est d'obtenir un masque de lithographie de bonne qualité pour structurer la couche diélectrique et la deuxième électrode.

Selon une caractéristique de l'invention, le procédé comporte une étape j) consistant à former une couche d'encapsulation sur la deuxième électrode structurée lors de l'étape h), l'étape j) étant exécutée après l'étape i).

Ainsi, un avantage procuré est de protéger le calculateur de l'air et de l'humidité.

Selon une caractéristique de l'invention, la couche diélectrique structurée lors de l'étape c) présente un pas, noté p, et dans lequel les étapes d') et e) sont exécutées de sorte que la première électrode et la couche mémoire présentent respectivement des première et deuxième épaisseurs, notée $E_1$ et $E_2$, vérifiant :

$$\frac{p}{2} \leq E_1 + E_2 \leq p$$

Ainsi, de telles épaisseurs de la première électrode et de la couche mémoire permettent d'obtenir une topologie de surface quasi-plane de manière à faciliter la formation de la deuxième électrode lors de l'étape f), ce qui permet de s'affranchir d'une étape de formation d'un oxyde et d'une étape de polissage mécano-chimique de l'oxyde.

L'invention a également pour objet un calculateur à réseaux de neurones récurrents obtenu par un procédé conforme à l'invention.

## Brève description des dessins

D'autres caractéristiques et avantages apparaîtront dans l'exposé détaillé de différents modes de réalisation de l'invention, l'exposé étant assorti d'exemples et de référence aux dessins joints.

Figures la à 1g sont des vues schématiques en coupe illustrant différentes étapes d'un procédé selon l'invention, la coupe étant effectuée suivant la normale à la surface du substrat.

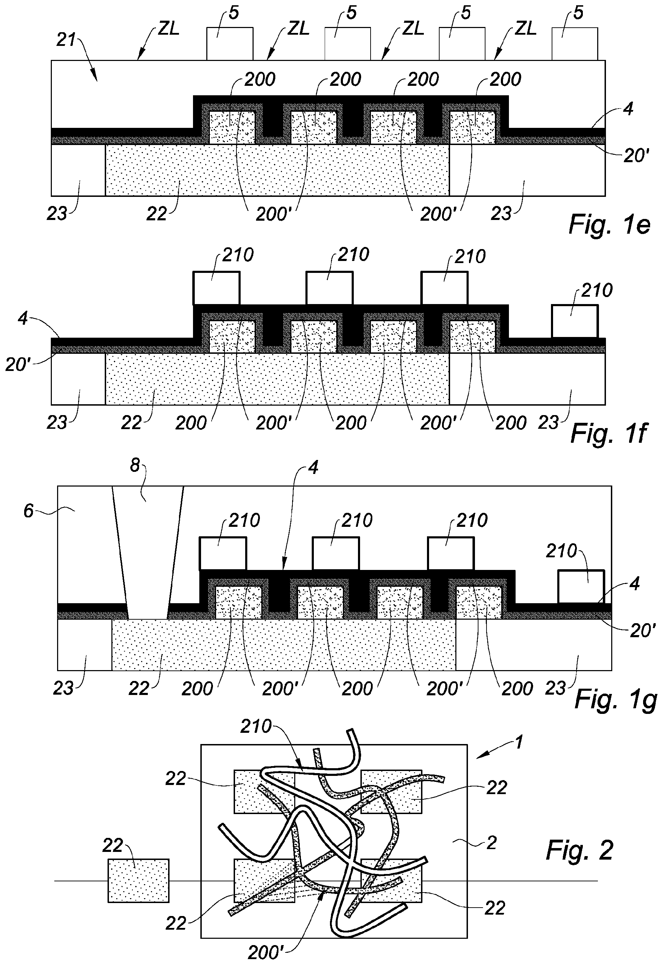

Figure 2 est une vue schématique de dessus d'un calculateur obtenu par un procédé selon l'invention.

Il est à noter que les dessins décrits ci-avant sont schématiques et ne sont pas à l'échelle pas souci de lisibilité.

## Exposé détaillé des modes de réalisation

Les éléments identiques ou assurant la même fonction porteront les mêmes références pour les différents modes de réalisation, par souci de simplification.

Un objet de l'invention est un procédé de fabrication d'un calculateur 1 à réseaux de neurones récurrents, comportant les étapes successives :

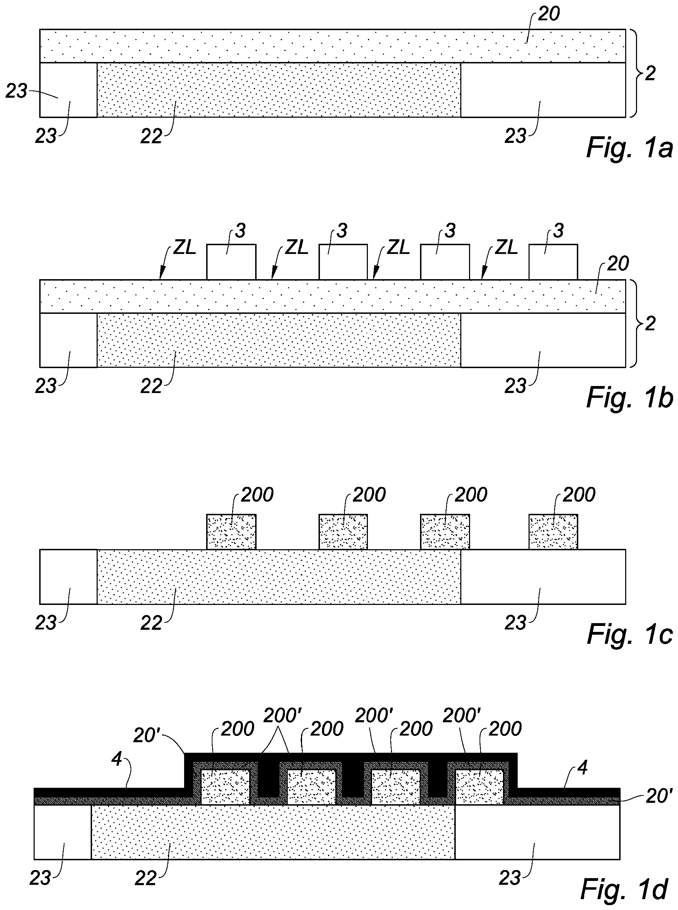

a) prévoir un substrat 2 comportant une couche diélectrique 20 (illustré à la figure la) ;
b) former une première couche 3 de copolymères à blocs sur une partie de la couche diélectrique 20 de sorte que la couche diélectrique 20 présente des zones libres ZL avec une distribution spatiale aléatoire (illustré à la figure 1b) ;
c) graver les zones libres ZL de la couche diélectrique 20 de manière à structurer la couche diélectrique 20 ;
d) retirer la première couche 3 de copolymères à blocs (la situation à l'issue de l'étape d) est illustrée à la figure 1c) ;
d') former une première électrode 20' sur la couche diélectrique structurée 200 lors de l'étape c) ;
e) former une couche mémoire 4, de type mémoire résistive, sur la première électrode 20' (la situation à l'issue de l'étape e) est illustrée à la figure 1d) ;
f) former une deuxième électrode 21 sur la couche mémoire 4 ;
g) former une deuxième couche 5 de copolymère à blocs sur une partie de la deuxième électrode 21 de sorte que la deuxième électrode 21 présente des zones libres ZL avec une distribution spatiale aléatoire (la situation à l'issue de l'étape g) est illustrée à la figure le) ;
h) graver les zones libres ZL de la deuxième électrode 21 de manière à structurer la deuxième électrode 21 ;
i) retirer la deuxième couche 5 de copolymères à blocs (la situation à l'issue de l'étape i) est illustrée à la figure 1f).

## Substrat

La couche diélectrique 20 est avantageusement une couche d'oxyde, de préférence réalisée en $SiO_2$ ou en SiN. A titre d'exemples non limitatifs, la couche diélectrique 20 peut être formée sur le substrat 2 par un dépôt physique en phase vapeur (PVD), un dépôt chimique en phase vapeur (CVD), par ALD (« *Atomic Layer Deposition* » en langue anglaise) ou encore par oxydation thermique.

Le substrat 2 comporte préférentiellement une couche de métallisation 22 (pour la reprise de contact) et une couche d'un oxyde 23 tel que $SiO_2$ ou SiN. A titre d'exemple non limitatif, la couche de métallisation 22 peut être une structure du type Ti (10 nm)/AlCu (440 nm) / Ti (10 nm) / TiN (100 nm).

### Formation de la première couche de copolymères à blocs

L'étape b) comporte avantageusement les étapes successives :

b$_1$) former une couche d'un polymère aléatoire sur la couche diélectrique 20 ;
b$_2$) greffer la couche du polymère aléatoire sur une partie de la couche diélectrique 20 ;
b$_3$) former la première couche 3 de copolymères à blocs sur la couche du polymère aléatoire greffée lors de l'étape b$_2$) ;
b$_4$) retirer la couche du polymère aléatoire greffée.

Le polymère aléatoire de la couche formée lors de l'étape b$_1$) est avantageusement sélectionné dans le groupe comportant un copolymère statistique, un homopolymère, une monocouche auto-assemblée. Le polymère aléatoire est avantageusement choisi lors de l'étape b$_1$) de sorte que la force d'attraction entre chacun des blocs de monomères du copolymère à blocs et la couche de polymère aléatoire (i.e. la couche de fonctionnalisation) sont équivalentes.

L'étape b$_2$) peut être exécutée à l'aide d'un traitement thermique, tel qu'un recuit thermique, ou par photoréticulation. La couche du polymère aléatoire qui n'a pas été greffée lors de l'étape b$_2$) est préférentiellement retirée à l'aide d'un traitement humide.

La première couche 3 de copolymères à blocs formée lors de l'étape b$_3$) est préférentiellement structurée à l'aide d'un recuit thermique.

A titre d'exemple, l'étape b$_4$) peut être un retrait sélectif lorsque le polymère aléatoire et les copolymères à blocs de la première couche 3 possèdent deux phases. L'étape b$_4$) peut être exécutée à l'aide d'un traitement UV suivi d'un développement par voie humide. L'étape b$_4$) peut également être exécutée par une gravure plasma.

Les copolymères à blocs de la première couche 3 sont avantageusement sélectionnés dans le groupe comportant :

- le polystyrène et le polyméthacrylate de méthyle, noté PS-PMMA ;
- le polystyrène et l'acide polylactique, noté PS-PLA ;
- le polystyrène et le poly(oxyde d'éthylène), noté PS-PEO ;
- le polystyrène et le polydiméthylsiloxane, noté PS-PDMS ;
- le polystyrène, le polyméthacrylate de méthyle, et le poly(oxyde d'éthylène), noté PS-PMMA-PEO,
- le polystyrène et le poly(2-vinyl pyridine), noté PS-P2VP.

A titre d'exemple, lorsque les copolymères à blocs de la première couche 3 sont du polystyrène-b-poly(méthacrylate de méthyle), noté PS-b-PMMA, de forme lamellaire, le polymère aléatoire de la couche de fonctionnalisation est avantageusement du polystyrène-r-poly(méthacrylate de méthyle), noté PS-r-PMMA, comportant préférentiellement 50% en masse de PS et 50% en masse de PMMA. L'étape b$_1$) est préférentiellement exécutée par un dépôt à la tournette (« *spin-coating*» en langue anglaise). Le dépôt à la tournette peut être exécuté en diluant le polymère aléatoire dans un solvant organique. Lorsque le polymère aléatoire est le PS-r-PMMA, le solvant organique peut être de l'acétate de l'éther monométhylique du propylène glycol, noté PGMEA. La solution du polymère aléatoire dilué dans le solvant organique peut présenter une concentration massique de l'ordre de 1,5%. L'étape b$_2$) peut être exécutée par un recuit thermique à une température de l'ordre de 250°C pendant une durée de l'ordre de 10 minutes. Le recuit thermique peut être exécuté sur une table chauffante ou dans un four. Lorsque le polymère aléatoire peut être réticulé, un tel recuit thermique permet la réticulation du polymère aléatoire. L'étape b$_2$) peut comporter une étape de rinçage au cours de laquelle le surplus de polymère aléatoire est enlevé à l'aide d'un solvant. Lorsque le polymère aléatoire est du PS-r-PMMA, le solvant est préférentiellement le PGMEA. L'étape b$_3$) est préférentiellement exécutée par un dépôt à la tournette. Le dépôt à la tournette peut être exécuté en diluant le copolymère à blocs dans un solvant organique. Lorsque le copolymère à blocs est le PS-b-PMMA, le solvant organique peut être du PGMEA. La solution du copolymère à blocs dilué dans le solvant organique peut présenter une concentration massique de l'ordre de 1,5%. L'étape b$_3$) est avantageusement suivie d'un recuit thermique permettant l'auto-assemblage du copolymère à blocs PS-b-PMMA et le retrait sélectif du PS-r-PMMA. Le recuit thermique est préférentiellement exécuté à une température de l'ordre de 250°C pendant une durée de l'ordre de 10 minutes.

La première couche 3 de copolymères à blocs formée lors de l'étape b) présente avantageusement une épaisseur comprise entre 30 nm et 50 nm.

### Structuration de la couche diélectrique

L'étape c) est préférentiellement exécutée par une gravure plasma, plus préférentiellement de type RIE (« *Reactive-Ion Etching* » en langue anglaise) ou de type ICP (« *Inductively Coupled Plasma* » en langue anglaise). A titre d'exemples non limitatifs, il est possible d'utiliser comme gaz des gaz fluorés.

### Retrait de la première couche de copolymères à blocs

L'étape d) est préférentiellement exécutée à l'aide d'un traitement UV suivi d'un développement par voie humide. L'étape d) peut également être exécutée par une gravure plasma.

## Formation de la première électrode

La première électrode 20' formée lors de l'étape d') est avantageusement réalisée dans au moins un matériau sélectionné dans le groupe comportant Ti, TiN, Pt, Zr, Al, Hf, Ta, TaN, C, Cu, Ag. La première électrode 20' peut être réalisée dans un alliage de ces matériaux. La première électrode 20' présente préférentiellement une épaisseur comprise entre 3 nm et 100 nm. La première électrode 20' est avantageusement formée lors de l'étape d') par un dépôt conforme de manière à obtenir une première électrode structurée 200', de préférence par ALD (« *Atomic Layer Deposition*» en langue anglaise). Ainsi, la première électrode structurée 200' formée lors de l'étape d') suit la topologie de la couche diélectrique structurée 200.

## Formation de la couche mémoire

La couche mémoire 4 est avantageusement réalisée dans au moins un matériau sélectionné dans le groupe comportant $HfO_2$, $Al_2O_3$, $SiO_2$, ZrO, un oxyde de titane, un chalcogénure, $Ta_2O_5$. La couche mémoire 4 peut être formée d'une pluralité de sous-couches réalisées dans ces matériaux. A titre d'exemples non limitatifs, le chalcogénure peut être GeSe ou GeSbTe.

La couche mémoire 4 présente avantageusement une épaisseur inférieure ou égale à 10 nm.

La couche diélectrique 20 structurée lors de l'étape c) présente avantageusement un pas, noté p. Les étapes d') et e) sont avantageusement exécutées de sorte que la première électrode 20' et la couche mémoire 4 présentent respectivement des première et deuxième épaisseurs, notée $E_1$ et $E_2$, vérifiant :

$$\frac{p}{2} \leq E_1 + E_2 \leq p$$

La couche mémoire 4 est avantageusement formée lors de l'étape e) par un dépôt conforme de manière à suivre la topologie de la première électrode structurée 200'.

### Formation de la deuxième électrode

La deuxième électrode 21 est avantageusement réalisée dans au moins un matériau sélectionné dans le groupe comportant Ti, TiN, Pt, Zr, Al, Hf, Ta, TaN, C, Cu, Ag. La deuxième électrode 21 peut être réalisée dans un alliage de ces matériaux. La deuxième électrode 21 présente préférentiellement une épaisseur comprise entre 3 nm et 100 nm. A titre d'exemples non limitatifs, la deuxième électrode 21 peut être formée sur la couche mémoire 4 par un dépôt physique en phase vapeur (PVD), un dépôt chimique en phase vapeur (CVD), ou encore par ALD (« *Atomic Layer Deposition* » en langue anglaise).

## Formation de la deuxième couche de copolymères à blocs

L'étape g) comporte avantageusement les étapes successives :

g₁) former une couche d'un polymère aléatoire sur la deuxième électrode ;

g₂) greffer la couche du polymère aléatoire sur une partie de la deuxième électrode ;

g₃) former la deuxième couche 5 de copolymères à blocs sur la couche du polymère aléatoire greffée lors de l'étape g₂) ;

g₄) retirer la couche du polymère aléatoire greffée.

Le polymère aléatoire de la couche formée lors de l'étape g₁) est avantageusement sélectionné dans le groupe comportant un copolymère statistique, un homopolymère, une monocouche auto-assemblée. Le polymère aléatoire est avantageusement choisi lors de l'étape g₁) de sorte que la force d'attraction entre chacun des blocs de monomères du copolymère à blocs et la couche de polymère aléatoire (i.e. la couche de fonctionnalisation) sont équivalentes.

L'étape g₂) peut être exécutée à l'aide d'un traitement thermique, tel qu'un recuit thermique, ou par photoréticulation. La couche du polymère aléatoire qui n'a pas été greffée lors de l'étape g₂) est préférentiellement retirée à l'aide d'un traitement humide.

La deuxième couche 5 de copolymères à blocs formée lors de l'étape g₃) est préférentiellement structurée à l'aide d'un recuit thermique.

A titre d'exemple, l'étape g₄) peut être un retrait sélectif lorsque le polymère aléatoire et les copolymères à blocs de la deuxième couche 5 possèdent deux phases. L'étape g₄) peut être exécutée à l'aide d'un traitement UV suivi d'un développement par voie humide. L'étape g₄) peut également être exécutée par une gravure plasma.

Les copolymères à blocs de la deuxième couche 5 sont avantageusement sélectionnés dans le groupe comportant :

- le polystyrène et le polyméthacrylate de méthyle, noté PS-PMMA ;
- le polystyrène et l'acide polylactique, noté PS-PLA ;
- le polystyrène et le poly(oxyde d'éthylène), noté PS-PEO ;
- le polystyrène et le polydiméthylsiloxane, noté PS-PDMS ;
- le polystyrène, le polyméthacrylate de méthyle, et le poly(oxyde d'éthylène), noté PS-PMMA-PEO,
- le polystyrène et le poly(2-vinyl pyridine), noté PS-P2VP.

A titre d'exemple, lorsque les copolymères à blocs de la deuxième couche 5 sont du polystyrène-b-poly(méthacrylate de méthyle), noté PS-b-PMMA, de forme lamellaire, le polymère aléatoire de la couche de fonctionnalisation est avantageusement du polystyrène-r-poly(méthacrylate de méthyle), noté PS-r-PMMA, comportant préférentiellement 50% en masse de PS et 50% en masse de PMMA. L'étape $g_1$) est préférentiellement exécutée par un dépôt à la tournette (« *spin-coating»* en langue anglaise). Le dépôt à la tournette peut être exécuté en diluant le polymère aléatoire dans un solvant organique. Lorsque le polymère aléatoire est le PS-r-PMMA, le solvant organique peut être de l'acétate de l'éther monométhylique du propylène glycol, noté PGMEA. La solution du polymère aléatoire dilué dans le solvant organique peut présenter une concentration massique de l'ordre de 1,5%. L'étape $g_2$) peut être exécutée par un recuit thermique à une température de l'ordre de 250°C pendant une durée de l'ordre de 10 minutes. Le recuit thermique peut être exécuté sur une table chauffante ou dans un four. Lorsque le polymère aléatoire peut être réticulé, un tel recuit thermique permet la réticulation du polymère aléatoire. L'étape $g_2$) peut comporter une étape de rinçage au cours de laquelle le surplus de polymère aléatoire est enlevé à l'aide d'un solvant. Lorsque le polymère aléatoire est du PS-r-PMMA, le solvant est préférentiellement le PGMEA. L'étape $g_3$) est préférentiellement exécutée par un dépôt à la tournette. Le dépôt à la tournette peut être exécuté en diluant le copolymère à blocs dans un solvant organique. Lorsque le copolymère à blocs est le PS-b-PMMA, le solvant organique peut être du PGMEA. La solution du copolymère à blocs dilué dans le solvant organique peut présenter une concentration massique de l'ordre de 1,5%. L'étape $g_3$) est avantageusement suivie d'un recuit thermique permettant l'auto-assemblage du copolymère à blocs PS-b-PMMA et le retrait sélectif du PS-r-PMMA. Le recuit thermique est préférentiellement exécuté à une température de l'ordre de 250°C pendant une durée de l'ordre de 10 minutes.

La deuxième couche 5 de copolymères à blocs formée respectivement lors de l'étape g) présente avantageusement une épaisseur comprise entre 30 nm et 50 nm.

### Structuration de la deuxième électrode

L'étape h) est préférentiellement exécutée par une gravure plasma. A titre d'exemples non limitatifs, il est possible d'utiliser comme gaz $O_2$, Ar, $COH_2$, $N_2H_2$. L'étape h) peut être également exécutée à l'aide d'un traitement UV suivi d'un développement humide (e.g. acide acétique).

### Retrait de la deuxième couche de copolymères à blocs

L'étape i) est préférentiellement exécutée à l'aide d'un traitement UV suivi d'un développement par voie humide. L'étape i) peut également être exécutée par une gravure plasma.

### Encapsulation

Comme illustré à la figure 1g, le procédé comporte avantageusement une étape j) consistant à former une couche d'encapsulation 6 sur la deuxième électrode structurée 210 lors de l'étape h), l'étape j) étant exécutée après l'étape i). La couche d'encapsulation 6 est préférentiellement une couche d'un oxyde tel que $SiO_2$ ou SiN.

### Contacts électriques

Comme illustré à la figure 1g, le procédé comporte préférentiellement une étape k) consistant à former un plot 8 de contact électrique, en contact avec la couche de métallisation 22. L'étape k) est exécutée après l'étape j). L'étape k) comporte une étape de gravure de la couche d'encapsulation 6 formée sur la deuxième électrode structurée 210.

L'invention ne se limite pas aux modes de réalisation exposés. L'homme du métier est mis à même de considérer leurs combinaisons techniquement opérantes, et de leur substituer des équivalents.

### Revendications

1. Procédé de fabrication d'un calculateur (1) à réseaux de neurones récurrents, comportant les étapes successives :

   a) prévoir un substrat (2) comportant une couche diélectrique (20) ;
   b) former une première couche (3) de copolymères à blocs sur une partie de la couche diélectrique (20) de sorte que la couche diélectrique (20) présente des zones libres (ZL) avec une distribution spatiale aléatoire ;
   c) graver les zones libres (ZL) de la couche diélectrique (20) de manière à structurer la couche diélectrique (20) ;
   d) retirer la première couche (3) de copolymères à blocs ;
   d') former une première électrode (20') sur la couche diélectrique structurée (200) lors de l'étape c) ;
   e) former une couche mémoire (4), de type mémoire résistive, sur la première électrode (20');
   f) former une deuxième électrode (21) sur la couche mémoire ;
   g) former une deuxième couche (5) de copolymère à blocs sur une partie de la deuxième électrode (21) de sorte que la deuxième électrode (21) présente des zones libres (ZL) avec une distribution spatiale aléatoire ;
   h) graver les zones libres (ZL) de la deuxième électrode (21) de manière à structurer la deuxième électrode (21) ;
   i) retirer la deuxième couche (5) de copolymères à blocs.

2.  Procédé selon la revendication 1, dans lequel l'étape b) comporte les étapes successives :

    $b_1$) former une couche d'un polymère aléatoire sur la couche diélectrique (20) ;
    $b_2$) greffer la couche du polymère aléatoire sur une partie de la couche diélectrique (20) ;
    $b_3$) former la première couche (3) de copolymères à blocs sur la couche du polymère aléatoire greffée lors de l'étape $b_2$) ;
    $b_4$) retirer la couche du polymère aléatoire greffée.

3.  Procédé selon la revendication 1 ou 2, dans lequel l'étape g) comporte les étapes successives :

    $g_1$) former une couche d'un polymère aléatoire sur la deuxième électrode (21) ;
    $g_2$) greffer la couche du polymère aléatoire sur une partie de la deuxième électrode (21) ;
    $g_3$) former la deuxième couche (5) de copolymères à blocs sur la couche du polymère aléatoire greffée lors de l'étape $g_2$) ;
    $g_4$) retirer la couche du polymère aléatoire greffée.

4.  Procédé selon la revendication 2 ou 3, dans lequel le polymère aléatoire est sélectionné dans le groupe comportant un copolymère statistique, un homopolymère, une monocouche auto-assemblée.

5.  Procédé selon l'une des revendications 1 à 4, dans lequel les copolymères à blocs de la première couche (3) et de la deuxième couche (5) sont sélectionnés dans le groupe comportant :

    - le polystyrène et le polyméthacrylate de méthyle, noté PS-PMMA ;
    - le polystyrène et l'acide polylactique, noté PS-PLA ;
    - le polystyrène et le poly(oxyde d'éthylène), noté PS-PEO ;
    - le polystyrène et le polydiméthylsiloxane, noté PS-PDMS ;
    - le polystyrène, le polyméthacrylate de méthyle, et le poly(oxyde d'éthylène), noté PS-PMMA-PEO,
    - le polystyrène et le poly(2-vinyl pyridine), noté PS-P2VP.

6.  Procédé selon l'une des revendications 1 à 5, dans lequel la couche mémoire (4) est réalisée dans au moins un matériau sélectionné dans le groupe comportant $HfO_2$, $Al_2O_3$, $SiO_2$, $ZrO$, un oxyde de titane, un chalcogénure, $Ta_2O_5$.

7.  Procédé selon l'une des revendications 1 à 6, dans lequel les première et deuxième électrodes (20', 21) sont réalisées dans au moins un matériau sélectionné dans le groupe comportant Ti, TiN, Pt, Zr, Al, Hf, Ta, TaN, C, Cu, Ag.

8.  Procédé selon l'une des revendications 1 à 7, dans lequel la première couche (3) de copolymères à blocs et la deuxième couche (5) de copolymères à blocs formées respectivement lors des étapes b) et g) présentent une épaisseur comprise entre 30 nm et 50 nm.

9.  Procédé selon l'une des revendications 1 à 8, comportant une étape j) consistant à former une couche d'encapsulation (6) sur la deuxième électrode structurée (210) lors de l'étape h), l'étape j) étant exécutée après l'étape i).

10. Procédé selon l'une des revendications 1 à 9, dans lequel la couche diélectrique (20) structurée lors de l'étape c) présente un pas, noté p, et dans lequel les étapes d') et e) sont exécutées de sorte que la première électrode (20') et la couche mémoire (4) présentent respectivement des première et deuxième épaisseurs, notée $E_1$ et $E_2$, vérifiant :

$$\frac{p}{2} \le E_1 + E_2 \le p$$

11. Calculateur (1) à réseaux de neurones récurrents obtenu par le procédé selon l'une des revendications 1 à 10.

**Patentansprüche**

1.  Verfahren zur Herstellung eines Rechners (1) mit rekurrenten neuronalen Netzen, das folgende aufeinanderfolgende Schritte umfasst:

    a) Bereitstellen eines Substrats (2) mit einer dielektrischen Schicht (20);
    b) Bilden einer ersten Schicht (3) aus Blockcopolymeren auf einem Abschnitt der dielektrischen Schicht (20) derart, dass die dielektrische Schicht (20) freie Bereiche (ZL) mit einer zufälligen räumlichen Verteilung aufweist;
    c) Ätzen der freien Bereiche (ZL) der dielektrischen Schicht (20), damit die dielektrische Schicht (20) strukturiert wird;
    d) Entfernen der ersten Schicht (3) aus Blockcopolymeren;
    d') Bilden einer ersten Elektrode (20') auf der in Schritt c) strukturierten dielektrischen Schicht (200);
    e) Bilden einer Speicherschicht (4) vom Typ resistiver Speicher auf der ersten Elektrode (20');
f) Bilden einer zweiten Elektrode (21) auf der Speicherschicht;
g) Bilden einer zweiten Schicht (5) aus Blockcopolymeren auf einem Abschnitt der zweiten Elektrode (21) derart, dass die zweite Elektrode (21) freie Bereiche (ZL) mit einer zufälligen räumlichen Verteilung aufweist;
h) Ätzen der freien Bereiche (ZL) der zweiten Elektrode (21), damit die zweite Elektrode (21) strukturiert wird;
i) Entfernen der zweiten Schicht (5) aus Blockcopolymeren.

2. Verfahren nach Anspruch 1, wobei Schritt b) folgende aufeinanderfolgende Schritte umfasst:

   b₁) Bilden einer Schicht aus einem Polymer mit zufälliger Verteilung auf der dielektrischen Schicht (20);
   b₂) Aufpfropfen der Schicht aus dem Polymer mit zufälliger Verteilung auf einem Abschnitt der dielektrischen Schicht (20);
   b₃) Bilden der ersten Schicht (3) aus Blockcopolymeren auf der Schicht aus dem Polymer mit zufälliger Verteilung, das in Schritt b₂) aufgepfropft wurde;
   b₄) Entfernen der Schicht aus dem aufgepfropften Polymer mit zufälliger Verteilung.

3. Verfahren nach Anspruch 1 oder 2, wobei Schritt g) folgende aufeinanderfolgende Schritte umfasst:

   g₁) Bilden einer Schicht aus einem Polymer mit zufälliger Verteilung auf der zweiten Elektrode (21);
   g₂) Aufpfropfen der Schicht aus dem Polymer mit zufälliger Verteilung auf einem Abschnitt der zweiten Elektrode (21);
   g₃) Bilden der zweiten Schicht (5) aus Blockcopolymeren auf der Schicht aus dem Polymer mit zufälliger Verteilung, das in Schritt g₂) aufgepfropft wurde;
   g₄) Entfernen der Schicht aus dem aufgepfropften Polymer mit zufälliger Verteilung.

4. Verfahren nach Anspruch 2 oder 3, wobei das Polymer mit zufälliger Verteilung aus der Gruppe ausgewählt wird, die ein statistisches Copolymer, ein Homopolymer und eine durch Selbstorganisation gebildete Monoschicht umfasst.

5. Verfahren nach einem der Ansprüche 1 bis 4, wobei die Blockcopolymere der ersten Schicht (3) und der zweiten Schicht (5) aus der Gruppe ausgewählt werden, die Folgendes umfasst:

   - Polystyrol und Polymethylmethacrylat, Kurzzeichen PS-PMMA;
   - Polystyrol und Polymilchsäure, Kurzzeichen PS-PLA;
   - Polystyrol und Polyethylenoxid, Kurzzeichen PS-PEO;
   - Polystyrol und Polydimethylsiloxan, Kurzzeichen PS-PDMS;
   - Polystyrol, Polymethylmethacrylat und Polyethylenoxid, Kurzzeichen PS-PMMA-PEO;
   - Polystyrol und Poly(2-vinylpyridin), Kurzzeichen PS-P2VP.

6. Verfahren nach einem der Ansprüche 1 bis 5, wobei die Speicherschicht (4) aus mindestens einem Material gefertigt wird, das aus der Gruppe umfassend $HfO_2$, $Al_2O_3$, $SiO_2$, ZrO, ein Titanoxid, ein Chalkogenid und $Ta_2O_5$ ausgewählt ist.

7. Verfahren nach einem der Ansprüche 1 bis 6, wobei die erste und zweite Elektrode (20', 21) aus mindestens einem Material gefertigt werden, das aus der Gruppe umfassend Ti, TiN, Pt, Zr, Al, Hf, Ta, TaN, C, Cu, Ag ausgewählt ist.

8. Verfahren nach einem der Ansprüche 1 bis 7, wobei die erste Schicht (3) aus Blockcopolymeren und die zweite Schicht (5) aus Blockcopolymeren, die in Schritt b) beziehungsweise g) gebildet wird, eine Dicke zwischen 30 nm und 50 nm aufweisen.

9. Verfahren nach einem der Ansprüche 1 bis 8, das einen Schritt j) umfasst, der im Bilden einer Verkapselungsschicht (6) auf der in Schritt h) strukturierten zweiten Elektrode (210) besteht, wobei Schritt j) nach Schritt i) ausgeführt wird.

10. Verfahren nach einem der Ansprüche 1 bis 9, wobei die in Schritt c) strukturierte dielektrische Schicht (20) einen mit p bezeichneten Abstand aufweist, und wobei Schritt d') und e) derart ausgeführt werden, dass die erste Elektrode (20') und die Speicherschicht (4) eine mit $E_1$ beziehungsweise $E_2$ bezeichnete erste beziehungsweise zweite Dicke aufweisen, wobei Folgendes erfüllt wird:

$$\frac{p}{2} \le E_1 + E_2 \le p$$

11. Rechner (1) mit rekurrenten neuronalen Netzen, der mit dem Verfahren nach einem der Ansprüche 1 bis 10 erhalten wird.

**Claims**

1. Process for the manufacture of a recurrent neural network calculator (1), comprising the successive stages:

a) providing a substrate (2) comprising a dielectric layer (20);
b) forming a first layer (3) of block copolymers on a part of the dielectric layer (20), so that the dielectric layer (20) exhibits free zones (FZ) with a random spatial distribution;
c) etching the free zones (FZ) of the dielectric layer (20), so as to structure the dielectric layer (20);
d) removing the first layer (3) of block copolymers;
d') forming a first electrode (20') on the dielectric layer structured (200) during stage c);
e) forming a memory layer (4), of resistive memory type, on the first electrode (20');
f) forming a second electrode (21) on the memory layer;
g) forming a second layer (5) of block copolymers on a part of the second electrode (21), so that the second electrode (21) exhibits free zones (FZ) with a random spatial distribution;
h) etching the free zones (FZ) of the second electrode (21), so as to structure the second electrode (21);
i) removing the second layer (5) of block copolymers.

2. Process according to Claim 1, in which stage b) comprises the successive stages:

$b_1$) forming a layer of a random polymer on the dielectric layer (20);
$b_2$) grafting the layer of the random polymer to a part of the dielectric layer (20);
$b_3$) forming the first layer (3) of block copolymers on the layer of the random polymer grafted during stage $b_2$);
$b_4$) removing the grafted layer of the random polymer.

3. Process according to Claim 1 or 2, in which stage g) comprises the successive stages:

$g_1$) forming a layer of a random polymer on the second electrode (21);
$g_2$) grafting the layer of the random polymer to a part of the second electrode (21);
$g_3$) forming the second layer (5) of block copolymers on the layer of the random polymer grafted during stage $g_2$);
$g_4$) removing the grafted layer of the random polymer.

4. Process according to Claim 2 or 3, in which the random polymer is selected from the group consisting of a statistical copolymer, a homopolymer and a self-assembled monolayer.

5. Process according to one of Claims 1 to 4, in which the block copolymers of the first layer (3) and of the second layer (5) are selected from the group consisting of:

- polystyrene and polymethyl methacrylate, denoted PS-PMMA;
- polystyrene and polylactic acid, denoted PS-PLA;
- polystyrene and poly(ethylene oxide), denoted PS-PEO;
- polystyrene and polydimethylsiloxane, denoted PS-PDMS;
- polystyrene, polymethyl methacrylate and poly(ethylene oxide), denoted PS-PMMA-PEO;
- polystyrene and poly(2-vinylpyridine), denoted PS-P2VP.

6. Process according to one of Claims 1 to 5, in which the memory layer (4) is made of at least one material selected from the group consisting of $HfO_2$, $Al_2O_3$, $SiO_2$, $ZrO$, a titanium oxide, a chalcogenide and $Ta_2O_5$.

7. Process according to one of Claims 1 to 6, in which the first and second electrodes (20', 21) are made of at least one material selected from the group consisting of Ti, TiN, Pt, Zr, Al, Hf, Ta, TaN, C, Cu and Ag.

8. Process according to one of Claims 1 to 7, in which the first layer (3) of block copolymers and the second layer (5) of block copolymers respectively formed during stages b) and g) exhibit a thickness of between 30 nm and 50 nm.

9. Process according to one of Claims 1 to 8, comprising a stage j) consisting in forming an encapsulation layer (6) on the second electrode structured (210) during stage h), stage j) being carried out after stage i).

10. Process according to one of Claims 1 to 9, in which the dielectric layer (20) structured during stage c) exhibits a pitch, denoted p, and in which stages d') and e) are carried out so that the first electrode (20') and the memory layer (4) respectively exhibit first and second thicknesses, denoted $E_1$ and $E_2$, adhering to:

$$\frac{p}{2} \le E_1 + E_2 \le p$$

11. Recurrent neural network calculator (1) obtained by the process according to one of Claims 1 to 10.

Fig. 1a

Fig. 1b

Fig. 1c

Fig. 1d

Fig. 1e

Fig. 1f

Fig. 1g

Fig. 2

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **E.C. DEMIS et al.** AtoMïc switch networks - nanoar-chitectonic design of a complex system for natural computing. *Nanotechnology,* 2015, vol. 26, 204003